(19) Europäisches Patentamt
European Patent Office
Office européen des brevets

(11) **EP 4 061 106 A1**

(12) **EUROPÄISCHE PATENTANMELDUNG**

(43) Veröffentlichungstag:
21.09.2022  Patentblatt 2022/38

(21) Anmeldenummer: 22157647.3

(22) Anmeldetag: **21.02.2022**

(51) Internationale Patentklassifikation (IPC):
**H05K 7/20** (2006.01)

(52) Gemeinsame Patentklassifikation (CPC):
**H05K 7/20927; H05K 7/20945**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **18.03.2021  DE 102021106599**

(71) Anmelder: **MAN Truck & Bus SE**
**80995 München (DE)**

(72) Erfinder:
• **Ralev, Iliya**
**80995 München (DE)**
• **Knorr, Marcus Joseph**
**80995 München (DE)**

(74) Vertreter: **v. Bezold & Partner Patentanwälte - PartG mbB**
**Ridlerstraße 57**
**80339 München (DE)**

(54) **FLÜSSIGKEITSGEKÜHLTER WECHSELRICHTER ZUR ANSTEUERUNG EINES ELEKTRISCHEN ANTRIEBSMOTORS EINES FAHRZEUGS**

(57)    Die Erfindung betrifft einen flüssigkeitsgekühlter Wechselrichter (1) zur Ansteuerung eines elektrischen Antriebsmotors eines Fahrzeugs. Der Wechselrichter (1) umfasst eine Leistungseinheit (2), aufweisend eine auf einer Oberseite eines Substrats (3) angeordnete, Leistungs-Halbleiterelemente (4) aufweisende Schaltungsanordnung. Der Wechselrichter (1) umfasst ferner eine Temperiervorrichtung (5) zur Kühlung der Leistungseinheit (2). Die Temperiervorrichtung (5) weist einen von einer Kühlflüssigkeit durchströmbaren Kühlkörper (6), auf den eine Unterseite des Substrats (3) aufgebracht ist. Die Temperiervorrichtung (5) weist ferner eine Haupt-Kühlmittelteilung (7), die sich zumindest abschnittsweise durch den Kühlkörper (6) erstreckt und eine von der Haupt-Kühlmittelleitung (7) abzweigende Bypass-Kühlmittelleitung (8) zur Reduzierung einer an die Leistungseinheit (2) übertragenen Kühlleistung. Die Temperiervorrichtung (5) weist ferner einen Volumenstromsteller (9), der ausgebildet ist, einen von der Haupt-Kühlmittelleitung (7) in die Bypass-Kühlmittelleitung (8) abgezweigten Volumenstromanteil (10) der Kühlflüssigkeit einzustellen, um die von der Temperiervorrichtung (5) an die Leistungseinheit (2) übertragene Kühlleistung zu beeinflussen.

Die Erfindung betrifft ferner ein Kraftfahrzeug, vorzugsweise Nutzfahrzeug, umfassend den flüssigkeitsgekühlten Wechselrichter (1).

FIG. 3

EP 4 061 106 A1

**Beschreibung**

Die Erfindung betrifft einen flüssigkeitsgekühlten Wechselrichter zur Ansteuerung eines elektrischen Antriebsmotors eines Fahrzeugs. Die Erfindung betrifft ferner ein Kraftfahrzeug, vorzugsweise Nutzfahrzeug, umfassend einen flüssigkeitsgekühlten Wechselrichter.

Kraftfahrzeuge mit elektrifiziertem Antriebsstrang besitzen ein Gleichstromnetz, das die elektrische Energie eines Traktionsenergiespeichers (beispielsweise einer Hochvolt-Traktionsbatterie) z. B. an den elektrischen Antriebsmotor des Kraftfahrzeuges überträgt. Der elektrische Antriebsmotor wird in der Regel nicht mit der Gleichspannung des Gleichstromnetzes versorgt, sondern mit Wechselstrom, mehrphasigem Drehstrom, gepulster Gleichspannung oder einer Gleichspannung mit einer vom Gleichstromnetz abweichenden Spannung. Deshalb ist ein Wechselrichter zwischen dem Gleichstromnetz und dem elektrischen Antriebsmotor angeordnet. Der Wechselrichter hat dabei die Aufgabe, den Gleichstrom des Gleichstromnetzes in das jeweilige Stromprofil umzuformen und umgekehrt, beispielsweise zur Rekuperation von Bewegungsenergie des Kraftfahrzeuges. Somit liegen gekoppelte Gleich- und Wechselstromnetze vor.

Bei einem Wechselrichter besteht ein Kühlbedarf insbesondere für die stromführende Leistungsstufe, in der die Wandlung des Stroms stattfindet. Insbesondere bei leistungsfähigen Wechselrichtern werden durch die Leistungsstufe relativ hohe Ströme gewandelt und z. B. an einen Antriebsmotor übertragen. Die Wandlung von Strom ist verlustbehaftet. Entstehende Verlustleistung wird in Form eines thermischen Verlusteintrags bzw. in Form von Verlustwärme abgegeben. Dadurch unterliegt die Leistungsstufe durch die thermische Belastung hervorgerufenen Verschleißeffekten, die die Lebensdauer der Leistungsstufe und damit des Wechselrichters begrenzen.

Aus der Praxis ist es bekannt, Wechselrichter aktiv zu kühlen. In bekannten Systemen mit einer aktiven Kühlung wird der Wechselrichter mit einem Kühlmittel, bspw. mit Luft oder mit Kühlflüssigkeit, durchströmt. Ein Teil der im Wechselrichter entstehenden Verlustwärme wird durch das Kühlmittel aufgenommen und abtransportiert. Wenn keine oder nur niedrige Ströme durch die Leistungsstufe übertragen werden, entsteht keine oder nur relativ wenig Verlustwärme in der Leistungsstufe, sodass auch eine Übertragung von Kühlleistung nicht notwendig ist. Zugunsten der Energieeffizienz sind bekannte Systeme aus diesem Grund temperaturgeregelt, d. h. sie regeln die Temperatur des Kühlmittels oder den Durchfluss des Kühlmittels in Abhängigkeit der an der Leistungsstufe vorliegenden Temperatur. Werden an der Leistungsstufe höhere Temperaturen erfasst, wird das den Wechselrichter durchströmende Kühlmittel gekühlt oder der Volumenstrom erhöht und in der Folge eine relativ hohe Kühlleistung an die Leistungsstufe übertragen. Werden an der Leistungsstufe dagegen niedrigere Temperaturen erfasst, wird das Kühlmittel nicht oder weniger stark gekühlt oder der Volumenstrom verringert und in der Folge keine oder nur weniger Kühlleistung an die Leistungsstufe übertragen.

Nachteilig ergibt sich bei bekannten Systemen damit die Notwendigkeit eines Temperatursensors zur Erfassung der Temperatur an der Leistungsstufe und eines Klimakompressors oder vergleichbarer Mittel sowie zur Temperierung des Kühlmittels oder zur Regelung des Volumenstroms. Bekannte Kühlsysteme von Wechselrichtern sind damit technisch aufwändig.

Ein weiterer Nachteil liegt in der Trägheit bekannter Systeme. Durch die Rückführung der Temperatur an der Leistungsstufe als Regelgröße sowie durch den möglichen Temperierungsvorgang des Kühlmittels unterliegen bekannte Lösungen systembedingt einer gewissen Verzögerung, sodass die Kühlung der Temperaturentwicklung an der Leistungsstufe immer "nachläuft". Entsprechend wirkt sich dies nachteilig auf die Lebensdauer bekannter Wechselrichter aus.

Die Aufgabe der vorliegenden Erfindung ist es, eine Technik zur Temperierung, insbesondere zur Kühlung, von Wechselrichtern bereitzustellen, mit der Nachteile bekannter Ansätze vermieden werden können. Die Aufgabe der Erfindung ist es insbesondere, temperaturbedingte Verschleißerscheinungen der Leistungsstufe von Wechselrichtern in verbesserter Weise zu reduzieren.

Diese Aufgaben werden durch die Vorrichtung mit den Merkmalen des unabhängigen Anspruchs gelöst. Vorteilhafte Ausführungsformen und Anwendungen der Erfindung ergeben sich aus den abhängigen Ansprüchen und werden in der folgenden Beschreibung unter teilweiser Bezugnahme auf die Figuren näher erläutert.

Gemäß einem allgemeinen Gesichtspunkt der Erfindung wird ein flüssigkeitsgekühlter Wechselrichter bereitgestellt. Der Wechselrichter, auch als Inverter bezeichnet, ist in an sich bekannter Weise zur Ansteuerung eines elektrischen Antriebsmotors eines Fahrzeugs ausgebildet und wandelt hierzu Gleichspannung in Wechselspannung um. Der Wechselrichter kann ausgebildet sein, Wicklungen eines z. B. als motorisch und generatorisch betreibbare elektrische Maschine ausgebildeten Antriebsmotors bedarfsgerecht zu bestromen und dadurch im Antriebsmotor eine Drehzahl und ein Drehmoment, und damit einen gewünschten oder angeforderten Arbeitspunkt, einzustellen. Der Wechselrichter umfasst eine Leistungseinheit, aufweisend eine auf einer Oberseite eines Substrats angeordnete, Leistungs-Halbleiterelemente aufweisende Schaltungsanordnung.

Der Wechselrichter umfasst ferner eine Temperiervorrichtung zur Kühlung der Leistungseinheit. Zur Kühlung der Leistungseinheit kann die Temperiervorrichtung beispielsweise ausgebildet sein, Kühlleistung an die Leistungseinheit zu übertragen oder in der Leistungseinrichtung entstehende Verlustwärme bzw. einen thermischen Verlusteintrag aufzunehmen. Vorzugsweise wird dem Wechselrichter durch die Temperiervorrichtung Wärme entzogen, es ist jedoch auch denkbar, dass dem Wechselrichter Wärme zugeführt wird bzw. die Leistungseinheit durch die Temperiervorrichtung geheizt wird.

Die Temperiervorrichtung weist einen von einer Kühlflüssigkeit durchströmbaren Kühlkörper auf, auf den eine Unterseite des Substrats aufgebracht ist. In anderen Worten ist der Kühlkörper unterhalb des Substrats angeordnet und/oder befestigt, d. h. der Kühlkörper ist auf der in Bezug auf die Schaltungsanordnung abgewandten Seite des Substrats angebracht.

Die Temperiervorrichtung weist ferner eine Haupt-Kühlmittelteilung auf, die sich zumindest abschnittsweise durch den Kühlkörper erstreckt. Die Temperiervorrichtung weist ferner eine von der Haupt-Kühlmittelleitung abzweigende Bypass-Kühlmittelleitung auf. Die Bypass-Kühlmittelleitung dient bevorzugt zur Reduzierung einer an die Leistungseinheit übertragenen Kühlleistung. Die Bypass-Kühlmittelleitung kann als eine Nebenleitung zur zumindest abschnittsweisen Umgehung der Haupt-Kühlmittelleitung ausgebildet sein.

Die Temperiervorrichtung weist ferner einen Volumenstromsteller auf, der ausgebildet ist, einen von der Haupt-Kühlmittelleitung in die Bypass-Kühlmittelleitung abgezweigten Volumenstromanteil der Kühlflüssigkeit einzustellen, vorzugsweise um die von der Temperiervorrichtung an die Leistungseinheit übertragene Kühlleistung zu beeinflussen.

Ein besonderer Vorzug des erfindungsgemäßen Wechselrichters ist, dass mittels der Bypass-Kühlmittelleitung und des Volumenstromstellers eine gezielte Beeinflussung der an die Leistungseinheit übertragenen Kühlleistung ermöglicht wird, auch wenn eingangsseitig am Wechselrichter ein Kühlmittelstrom mit vorgegebener Durchflussrate und Temperatur anliegt. Die Temperiervorrichtung des Wechselrichters ist vorzugsweise an einen Flüssigkeits-Kühlkreislauf des Fahrzeugs angeschlossen, dessen Kühlmittelvolumenstrom und Kühlmitteltemperatur durch diesen Flüssigkeits-Kühlkreislauf vorgegeben ist. Beispielsweise können der am Wechselrichter bzw. dessen Temperiervorrichtung eingangsseitig anliegende Kühlmittelvolumenstrom und die Kühlmitteltemperatur konstant sein. Durch zweckmäßige Ansteuerung des Volumenstromstellers kann dennoch durch Einstellung des in die Bypass-Kühlmittelleitung abgezweigten Volumenanteils eine gezielte Beeinflussung der von der Temperiervorrichtung an die Leistungseinheit übertragenen Kühlleistung erzielt werden.

In einer vorteilhaften Ausführungsform kann der flüssigkeitsgekühlter Wechselrichter ferner eine Steuereinrichtung zur Ansteuerung des Volumenstromstellers aufweisen. Zudem kann die Steuereinrichtung ausgebildet sein, den Volumenstromsteller in Abhängigkeit von mindestens einer Größe anzusteuern, die ein Maß für einen vom Wechselrichter anzusteuernden Arbeitspunkt des Antriebsmotors und/oder die ein Maß, insbesondere eine Vorhersagegröße, für einen thermischen Verlusteintrag aus der Leistungseinheit in den Kühlkörper angibt. Der einzustellende Arbeitspunkt stellt eine Vorhersagegröße für den thermischen Verlusteintrag aus der Leistungseinheit in den Kühlkörper dar.

Dies ermöglicht eine besonders zuverlässige Steuerung der an die Leistungseinheit übertragenen Kühlleistung. Das Verwenden einer Steuergröße, die ein Maß für einen vom Wechselrichter anzusteuernden Arbeitspunkt des Antriebsmotors bzw. Vorhersagegröße, für einen thermischen Verlusteintrag angibt, ermöglicht eine prädiktive Temperierung der Leistungseinheit des Wechselrichters oder eine prädiktive Steuerung, da aus einer solchen Größe ein Maß für die von der Leistungseinheit des Wechselrichters erzeugten Verlustwärme ableitbar und/oder vorhersagbar ist. Entsprechend kann die Kühlleistung frühzeitig, quasi im Sinne einer Vorsteuerung, durch Aufteilen der Volumenströme zwischen HauptKühlmittelleitung und Bypass-Kühlmittelleitung angepasst werden. Dadurch können nicht nur zu hohe absolute Temperaturen der Leistungseinheit zuverlässig verhindert werden, sondern insbesondere auch Temperaturschwankungen des Leistungseinheit insgesamt reduziert werden. Im Rahmen der Erfindung wurde festgestellt, dass die Lebensdauer der Leistungseinheit nicht nur durch hohe absolute Temperaturen negativ beeinflusst wird, sondern insbesondere auch durch große relative Temperaturänderungen. Große relative Temperaturänderungen werden durch träg reagierende Systeme begünstigt, weswegen die schneller reagierende prädiktive Temperierung zur Vermeidung großer relativer Temperaturänderungen, wie hier vorgeschlagen, besonders vorteilhaft ist.

Beispielsweise ist denkbar, dass die Steuereinrichtung erfasst, dass vom Wechselrichter ein Arbeitspunkt des Antriebsmotors auf einem relativ hohen Leistungsniveau angesteuert werden soll, der durch relativ hohe vom Wechselrichter an den Antriebsmotor übertragene Ströme angesteuert wird und insofern auch eine hohe thermische Belastung für die Leistungseinheit darstellt. In diesem Beispiel kann die Steuereinrichtung ausgebildet sein, im Wesentlichen zeitgleich dazu den Volumenstromsteller derart anzusteuern, dass die durch den Kühlkörper strömende Kühlflüssigkeit größtenteils durch die Haupt-Kühlmittelleitung geleitet wird und eine relativ hohe Kühlleistung an die Leistungsstufe übertragen wird und zwar bereits im Wesentlichen zeitgleich zur Entstehung der Verlustwärme bzw. zeitgleich zum thermischen Verlusteintrag. In vorteilhafter Weise wird eine starke Erwärmung der Leistungseinheit vermieden.

Beispielsweise kann die mindestens eine Größe einen vom Wechselrichter einzustellenden Phasenstrom, ein vom Wechselrichter einzustellendes Drehmoment und/oder eine vom Wechselrichter einzustellende Drehzahl des Antriebsmotors umfassen. Diese Größen ermöglichen eine bessere Reduzierung von Temperaturschwankungen der Leistungsstufe im Vergleich zur Steuerung oder Regelung auf Basis der Temperatur der Leistungsstufe. Letzteres ermöglicht nur eine reaktive Steuerung bzw. Regelung.

Durch eine Ansteuerung des Volumenstromstellers in Abhängigkeit von einer Größe, die ein Maß für einen vom Wechselrichter anzusteuernden Arbeitspunkt angibt, kann die benötigte Kühlleistung über den Volumenstromsteller also nicht erst zeitlich versetzt, sondern vielmehr bereits im Wesentlichen vor und/oder zum Zeitpunkt der Abgabe von Verlustleistung in Form von Wärme angepasst werden. Hierbei ermöglicht die Kombination aus lokaler Aufteilung der Kühlmittelströme im Wechselrichter mittels der integrierten Bypass-Kühlmittelleitung und aus mindestens einer prädiktiven Steuerungsgröße für den zu erwartenden Wärmeeintrag durch die Leistungseinheit eine besondere zuverlässige Reduzierung von Temperaturschwankungen der Leistungseinheit.

Denkbar ist beispielsweise, dass die Steuereinrichtung erfasst, dass vom Wechselrichter ein relativ niedriger Phasenstrom einzustellen ist. In diesem Beispiel führen relativ niedrige Phasenströme zu relativ niedrigen Verlusten in der Leistungseinheit und zu Abstrahlung keiner oder relativ wenig Verlustwärme. Die Übertragung von Kühlleistung ist also nicht oder nur in begrenztem Ausmaß notwendig. Dann kann die Steuereinrichtung den Volumenstromsteller derart ansteuern, dass ein Großteil der durch den Kühlkörper strömenden Kühlflüssigkeit in die Bypass-Kühlmittelleitung abgezweigt wird, und damit zu einer Reduzierung der an die Leistungseinheit übertragenen Kühlleistung führt. Der Phasenstrom, das Drehmoment und/oder die Drehzahl stellen insbesondere deswegen besonders vorteilhafte Größen dar, die entstehende Verlustwärme direkt abhängig von diesen Größen ist. Dadurch wird die Trägheit der Temperiervorrichtung weiter reduziert.

Gemäß einer Weiterbildung der beiden letztgenannten Aspekte kann die Steuereinrichtung ausgebildet sein, zur Reduktion von Temperaturschwankungen den Volumenstromsteller derart anzusteuern, dass der mittels des Volumenstromstellers von der HauptKühlmittelleitung in die Bypass-Kühlmittelleitung abgezweigte Volumenstromanteil negativ korreliert ist mit einer von dem einzustellenden Arbeitspunkt abhängigen Höhe des thermischen Verlusteintrags aus der Leistungseinheit in den Kühlkörper. Alternativ oder ergänzend kann der mittels des Volumenstromstellers von der Haupt-Kühlmittelleitung in die Bypass-Kühlmittelleitung abgezweigte Volumenstromanteil negativ korreliert sein, mit einer Höhe eines vom Wechselrichter einzustellenden Phasenstroms und/oder Drehmoments.

Es ist bspw. denkbar, dass im Vorfeld empirisch ermittelte Beträge des thermischen Verlusteintrags, bspw. der Verlustwärme, für bestimmte diskrete Arbeitspunkte des elektrischen Antriebsmotors in der Steuereinrichtung hinterlegt sind. Ist ein aktuell einzustellender Arbeitspunkt einem relativ hohen thermischen Verlusteintrag zugeordnet, kann die Steuereinrichtung in diesem Beispiel ausgebildet sein, den Volumenstromsteller derart anzusteuern, dass nur ein relativ kleiner Volumenstromanteil in die Bypass-Kühlmittelleitung abgezweigt und damit eine relativ hohe Kühlleistung an die Leistungseinheit übertragen wird. Dies ermöglicht eine verbesserte Anpassung der übertragenen Kühlleistung an den tatsächlich entstehende thermischen Verlusteintrag.

Gemäß einem weiteren Aspekt kann die Steuereinrichtung ausgebildet sein, den Volumenstromsteller derart anzusteuern, dass der von der Haupt-Kühlmittelleitung in die Bypass-Kühlmittelleitung abgezweigte Volumenstromanteil größer 50 %, vorzugsweise größer 80 %, weiter vorzugsweise 100 %, des Volumenstroms der Kühlflüssigkeit entspricht, wenn kein Phasenstrom vom Wechselrichter am Antriebsmotor einzustellen ist. In anderen Worten wird der Volumenstrom größerenteils in die Bypass-Kühlmittelleitung abgezweigt, wenn kein Phasenstrom vom Wechselrichter am Antriebsmotor einzustellen ist, also wenn nur ein relativ niedriger thermischer Verlusteintrag entsteht. Dies wirkt sich vorteilhaft aus auf eine möglichst bedarfsgerechte Anpassung der Kühlleistung.

Gemäß einem weiteren Aspekt kann die Steuereinrichtung ausgebildet sein, den Volumenstromsteller derart anzusteuern, dass zur Übertragung einer niedrigen, an die Leistungseinheit übertragenen Kühlleistung ein überwiegender Volumenstromanteil der im Kühlkörper strömenden Kühlflüssigkeit mittels des Volumenstromstellers in die Bypass-Kühlmittelleitung abgezweigt wird. Alternativ oder ergänzend kann die Steuereinrichtung ausgebildet sein, den Volumenstromsteller derart anzusteuern, dass zur Übertragung einer hohen, an die Leistungseinheit übertragenen Kühlleistung kein Volumenstromanteil oder kein überwiegender Volumenstromanteil der im Kühlkörper strömenden Kühlflüssigkeit mittels des Volumenstromstellers in die Bypass-Kühlmittelleitung abgezweigt wird.

Gemäß einem weiteren Aspekt kann die Steuereinrichtung in eine die Leistungseinheit und die Temperiervorrichtung umfassende Baugruppe integriert sein. Beispielsweise die Steuereinrichtung baulich in ein Gehäuse integriert sein, dass ebenfalls die Leistungseinheit und die Temperiervorrichtung umhaust. Beispielsweise kann die Steuereinrichtung als Teil der elektronischen Steuerung des Wechselrichters umgesetzt sein. Die Steuereinrichtung kann hierbei ferner zur Ansteuerung der Leistungseinheit ausgebildet sein. Dies reduziert den technischen Aufwand weiter.

Alternativ kann die Steuereinrichtung baulich und/oder räumlich getrennt von einer die Leistungseinheit und die Temperiervorrichtung umfassenden Baugruppe angeordnet sein. Beispielsweise kann die Steuereinrichtung als separates Steuergerät oder als Funktionsmodul in einem anderen Steuergerät integriert sein und in Signalverbindung mit dem Volumenstromsteller stehen. In dieser Ausführungsvorrichtung bildet die Anordnung aus Leistungseinheit, Temperiervorrichtung und Steuereinrichtung den Wechselrichter aus.

In einer weiteren Ausführungsform kann der Volumenstromsteller eine Klappe umfassen, die geeignet ist, den in die Bypass-Kühlmittelleitung abzuzweigenden Volumenstromanteil zu beeinflussen. Die Klappe kann z. B. ausgebildet sein, die durch den Kühlkörper strömende Kühlflüssigkeit durch eine Anstellung variabel umzulenken. Dies stellt eine technisch besonders einfach umzusetzende Ausgestaltung des Volumenstromstellers dar.

In einer weiteren Ausführungsform kann das Substrat zur elektrischen Isolierung der Leistungseinheit eine Keramikplatte umfassen und/oder als Keramikplatte ausgebildet sein.

Keramik eignet sich durch seine hervorragenden elektrisch isolierenden Eigenschaften sowie durch seine Festigkeit besonders vorteilhaft als Material für das Substrat. Es wird jedoch betont, dass auch andere Substrate zum Einsatz kommen können.

In einer weiteren Ausführungsform kann die Leistungseinheit als IGBT- oder MOSFET-Leistungsstufe ausgebildet sein, umfassend zumindest ein mehrere Leistungs-Halbleiterelemente aufweisendes Leistungsmodul.

In einer weiteren Ausführungsform kann die Haupt-Kühlmittelleitung sich zumindest abschnittsweise entlang der Unterseite des Substrats durch den Kühlkörper erstrecken. Ferner kann die Bypass-Kühlmittelleitung sich auf einer in Bezug auf die Haupt-Kühlmittelleitung dem Substrat abgewandten Seite durch den Kühlkörper erstrecken. Hierbei verläuft die HauptKühlmittelleitung somit abschnittsweise zwischen Substrat und Bypass-Kühlmittelleitung. Alternativ oder ergänzend kann die Bypass-Kühlmittelleitung aus dem Kühlkörper herausgeführt sein und sich zumindest abschnittsweise an einer Außenseite des Kühlkörpers erstrecken.

Gemäß einem weiteren Aspekt kann die Bypass-Kühlmittelleitung in Bezug auf die die Temperiervorrichtung durchströmende Kühlflüssigkeit stromaufwärts der Leistungseinheit von der Haupt-Kühlmittelleitung abzweigen und/oder stromabwärts der Leistungseinheit in die Haupt-Kühlmittelleitung münden. Dies begünstigt eine gleichmäßige Kühlung der Leistungseinheit über deren ganzen Ausdehnung.

Gemäß einem weiteren Aspekt kann der Volumenstromsteller im Bereich einer Abzweigung der Bypass-Kühlmittelleitung von der Haupt-Kühlmittelleitung oder im Bereich einer Zusammenführung der Bypass-Kühlmittelleitung in die Haupt-Kühlmittelleitung angeordnet sein. Grundsätzlich ist auch denkbar, dass der Volumenstromsteller in der Haupt-Kühlmittelleitung oder der Bypass-Kühlmittelleitung angeordnet ist und die Abzweigung in die Bypass-Kühlmittelleitung bspw. durch Aufstauung des Kühlmittels erfolgt. Die Anordnung im Bereich einer Abzweigung der Bypass-Kühlmittelleitung von der Haupt-Kühlmittelleitung oder im Bereich einer Zusammenführung der Bypass-Kühlmittelleitung begünstigt eine besonders genaue Einstellung des in die Bypass-Kühlmittelleitung abgezweigten Volumenstromanteils.

In einer weiteren Ausführungsform weist der flüssigkeitsgekühlte Wechselrichter ferner einen im Bereich der Leistungseinheit angeordneten Temperatursensor auf, der ausgebildet ist, die Temperatur der Leistungseinheit zu erfassen. Gemäß dieser Ausführungsform ist die Steuereinrichtung ausgebildet, den Volumenstromsteller in Abhängigkeit von der erfassten Temperatur anzusteuern. Beispielsweise kann der über den Volumenstromsteller in die Bypass-Kühlmittelleitung abgezweigte Volumenstromanteil reduziert werden, wenn die erfasste Temperatur einen vorbestimmten Schwellenwert überschreitet. Ein solcher Temperatursensor ist insbesondere vorteilhaft in Ergänzung zu der vorgenannten Verwendung einer Größe, die ein Maß für den Arbeitspunkt des Antriebsmotors angibt, z. B. den einzustellenden Phasenstrom. Während letzte als prädiktive Größe verwendet werden kann, kann mit dem Temperatursensor die tatsächliche Temperaturänderung erfasst werden.

Die Erfindung umfasst ferner folgende Aspekte:
Der Wechselrichter kann ein Antriebswechselrichter sein. Der Wechselrichter kann ein wassergekühlter Pulswechselrichter sein. Der Wechselrichter kann ausgebildet sein, aus einer Batterie stammende Gleichspannung in die benötigte variable Wechselspannung, vorzugsweise eine mehrphasige, weiter vorzugsweise dreiphasige, Ausgangsspannung mit veränderlicher Amplitude, Phase und Frequenz umzuwandeln und an den elektrischen Antriebsmotor zu übertragen, der ausgebildet ist, sie in Antriebsleistung umzusetzen. In an sich bekannter Weise kann der Wechselrichter auch ausgebildet sein, bei umgekehrtem Stromfluss eine Wechselspannung in Gleichspannung zu wandeln. Dann kann der Wechselrichter ausgebildet sein, zur Rekuperation von Antriebsenergie Wechselspannung des elektrischen Antriebsmotors empfangen, in Gleichspannung zu wandeln und z. B. an eine Batterie zu übertragen.

Die Leistungseinheit des Wechselrichters ist vorzugsweise die Schaltungsanordnung, diejenige stromführende Komponente, in der die Wandlung von Gleichstrom in Wechselstrom stattfindet. Zur Wandlung von Strom kann die Schaltungsanordnung z. B. als Parallelschaltung oder H-Brückenschaltungen ausgebildet sein, in deren Ästen die Leistungs-Halbleiterelemente angeordnet sind. Durch gezielte Schaltung der Leistungs-Halbleiterelemente und eine dadurch bedingte gezielte Leitung des Stromflusses durch die Schaltungsanordnung, kann an einem Ausgang eine Wechselspannung abgegriffen werden. Lediglich beispielhaft können die Leistungs-Halbleiterelemente als Metall-Oxid-Halbleiter-Feldeffekttransistor (MOSFET) oder als Insulated Gate Bipolar Transistor (IGBT) ausgebildet sein. Die Leistungseinheit kann z. B. auch als Leistungsstufe ausgebildet sein. In der Leistungseinheit können Durchlass- und Schaltverluste entstehen, die hauptsächlich in Verlustwärme umgesetzt werden und damit einen thermischen Verlusteintrag darstellen.

Das Substrat kann als elektrisch isolierende Platte ausgeführt sein, z. B. als Keramik-Platte, die auch als Träger der Schaltungsanordnung dient. In anderen Worten kann das Substrat sowohl als elektrischer Isolator als auch als Trägerplatte für die Schaltungsanordnung fungieren. Die Dicke des Substrats kann nur wenige Millimeter, bspw. 1 - 10 mm, betragen.

Die Hauptkühlmittelleitung kann z. B. in einem Innenvolumen des Kühlkörpers einen Fluidführungskanal für die den Kühlkörper durchströmende Kühlflüssigkeit ausbilden. Die Haupt-Kühlmittelleitung ist vorzugsweise unmittelbar benachbart zur Unterseite des Substrats angeordnet. Strömt oder fließt Kühlflüssigkeit durch die Haupt-Kühlmittelleitung kann Kühlleistung von der Kühlflüssigkeit über das Substrat in die Leistungseinheit übertragen werden.

Die Erfindung betrifft ferner ein Fahrzeug, vorzugsweise ein Kraftfahrzeug umfassend einen flüssigkeitsgekühlten Wechselrichter wie in diesem Dokument beschrieben.

Gemäß einer bevorzugten Ausführungsform kann das Kraftfahrzeug einen elektrischen Antriebsmotor und ein Kühlsystem für den Antriebsmotor umfassen. In anderen Worten ist das Kraftfahrzeug vorzugsweise zumindest teilweise elektrisch angetrieben. Der HauptKühlmittelleitung der Temperiervorrichtung des Wechselrichters kann eingangsseitig eine Kühlflüssigkeit aus dem Kühlsystem des Kraftfahrzeugs zugeführt werden, deren Temperatur und Volumenstrom durch das Kühlsystem vorgegeben ist. Die Haupt-Kühlmittelleitung kann hierzu fluidisch mit einem, vorzugsweise mit konstantem Volumenstrom betriebenen, Kühlkreislauf des Kraftfahrzeugs verbunden sein. Der vom Kühlsystem des Kraftfahrzeugs am Wechselrichter bzw. an der Haupt-Kühlmittelleitung eingangsseitig anliegende (stromauf ankommende) Kühlmittel-Volumenstrom kann konstant sein.

Besonders vorzugsweise handelt es sich bei dem Kraftfahrzeug um ein Nutzfahrzeug. In diesem Fall kann es sich bei dem Kraftfahrzeug mit anderen Worten um ein Kraftfahrzeug handeln, das durch seine Bauart und Einrichtung zur Beförderung von Personen, zum Transport von Gütern oder zum Ziehen von Anhängerfahrzeugen ausgelegt ist. Beispielsweise kann es sich bei dem Kraftfahrzeug um einen Lastkraftwagen, einen Omnibus und oder einen Sattelzug handeln, der zumindest teilweise elektrisch angetrieben ist.

Die zuvor beschriebenen bevorzugten Ausführungsformen und Merkmale der Erfindung sind beliebig miteinander kombinierbar.

Einzelheiten und Vorteile der Erfindung werden im Folgenden unter Bezug auf die beigefügte Zeichnung beschrieben. Es zeigen:

Figur 1    eine exemplarische Darstellung der theoretisch ertragbaren Temperaturänderungen einer Leistungseinheit eines Wechselrichters;

Figur 2    einen exemplarischen Verlauf verschiedener Parameter eines Wechselrichters ohne Bypass bei konstantem Kühlmittelvolumenstrom im Übergang zwischen zwei Arbeitspunkten des elektrischen Antriebsmotors;

Figur 3    eine stark schematisierte Darstellung des Aufbaus eines flüssigkeitsgekühlten Wechselrichters gemäß einer Ausführungsform der Erfindung; und

Figur 4    einen exemplarischen Verlauf verschiedener Parameter des Wechselrichters aus Figur 3 bei konstantem Kühlmittelvolumenstrom im Übergang zwischen zwei Arbeitspunkten des elektrischen Antriebsmotors.

Gleiche oder funktional äquivalente Elemente sind in allen Figuren mit denselben Bezugszeichen bezeichnet und sind zum Teil nicht gesondert beschrieben.

Im Rahmen der Erfindung wurde beispielsweise folgendes festgestellt:
Verlustleistung in der Leistungseinheit eines Antriebswechselrichters:
In elektrifizierten Kraftfahrzeugen, insbesondere Nutzfahrzeugen, können zur Regelung der Antriebsmaschine(n) gekühlte Pulswechselrichter mit IGBT- oder MOSFET Leistungsstufen eingesetzt werden. Eine Leistungseinheit bzw. Leistungsstufe kann dabei aus mehreren Leistungsmodulen aufgebaut sein, in die die Halbleiter-Transistoren eingebaut werden. Die Funktion der Leistungsstufen ist das Einstellen eines Phasenstroms $I_{Phase}$, der in der elektrischen Maschine bzw. im elektrischen Antriebsmotor ein Drehmoment $M_{Motor}$ bewirkt. Der Phasenstrom kann dabei als abhängig vom sich in der Maschine einstellenden Drehmoment angenommen werden: $I_{Phase} = f(M_{Motor})$. In den folgenden Überlegungen wird exemplarisch auf MOSFET-Transistoren eingegangen, wobei ein Einsatz von IGBT-Schaltern alternativ möglich ist.

Die Leistungsstufen tragen auf Grund von Durchlass- und Schaltverlusten im Wesentlichen zum Verlustwärmeeintrag innerhalb des Pulswechselrichters bei. Durchlassverluste entstehen durch den Stromfluss über die Leistungstransistoren. Sie verhalten sich beim MOSFET ohmsch und nehmen quadratisch zum umgesetzten Strom zu:

$$P_{Verlust, Durchlass} = f(I_{Phase}^2) \text{ mit } I_{Phase} = f(M_{Motor}) \text{ folgt } P_{Verlust, Durchlass} = f(M_{Motor}^2)$$

Die Schaltverluste entstehen hauptsächlich während der Kommutierungsvorgänge beim Einund Ausschalten der Leistungstransistoren. Sie verhalten sich damit linear zur Häufigkeit des Ein- und Ausschalten, also der Schaltfrequenz $f_{Schalt}$. Zudem ist die Größe des geschalteten Stroms $I_{Phase}$ ausschlaggebend für die Schaltverluste. Somit ergibt sich:

$$P_{Verlust, Schalt} = f(f_{Schalt}, I_{Phase})$$

Bei Pulswechselrichtern in der Antriebstechnik von Kraftfahrzeugen, vorzugsweise Nutzfahrzeugen, ist diese Schaltfrequenz $f_{Schalt}$ variabel und wird in Abhängigkeit der Motordrehzahl $n_{Motor}$ und des Motordrehmoments $M_{Motor}$

eingestellt, um beispielsweise Effizienz oder Akustik des Systems zu optimieren.

$$f_{Schalt} = f(M_{Motor}, n_{Motor})$$

mit $f_{Schalt} = f(M_{Motor}, n_{Motor})$ und $I_{Phase} = f(M_{Motor})$ folgt $P_{Verlust, Schalt} = f(M_{Motor}, n_{Motor})$

Es zeigt sich, dass die Summe der Gesamtverlustleistung aus

$$P_{Verlust} = P_{Verlust, Durchlass} + P_{Verlust, Schalt}$$

durch das eingestellte Motordrehmoment sowie die eingestellte Drehzahl bestimmt wird - also dem Arbeitspunkt der elektrischen Maschine. Dabei ist das Drehmoment die dominierende Einflussgröße.

$$\rightarrow P_{Verlust} = f(n_{Motor}, M_{Motor})$$

In einem Kraftfahrzeug, vorzugsweise Nutzfahrzeug, ist der Arbeitspunkt des Antriebs extrem variierend. Gerade in städtischen Bereichen mit Bremsen/Rekuperieren und anschließendes Beschleunigen an Ampeln oder Bushaltestellen verändern sich Motordrehzahl und -moment ständig. Dadurch ist auch der Verlustleistungseintrag in die Leistungsstufe des Antriebswechselrichters über die Zeit extrem schwankend.

Thermische Einflüsse auf die Lebensdauer der Leistungseinheit oder des Leistungsmoduls

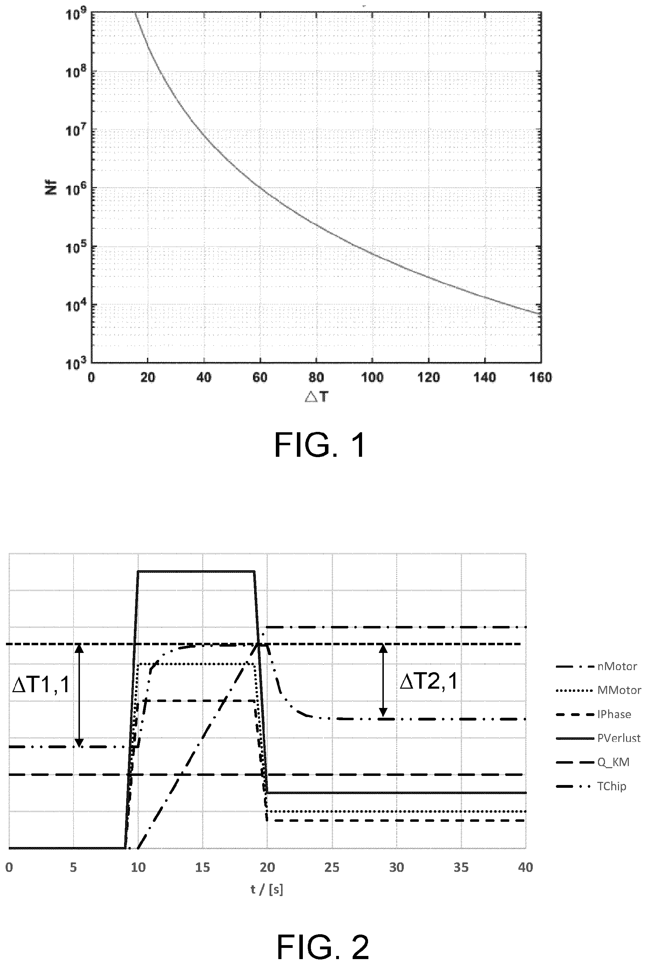

Eine wichtige Eigenschaft von Antriebswechselrichtern ist die Lebensdauer. Dabei spielt die Leistungseinheit oder Leistungsstufe eine wesentliche Rolle, denn die Lebensdauer von Halbleitern ist auf Grund von Verschleißeffekten begrenzt. Das Altern durch Überhitzung der Transistoren löst man im Grunde durch eine gute thermische Auslegung sowie eine Überwachung der Chip-Temperaturen über Software. Dennoch altern Chips durch thermische Zyklisierung auf Grund der sich ändernden Chiptemperaturen. Figur 1 zeigt die garantierte Anzahl $N_f$ von Temperaturänderungen $\Delta T$, die ein bestimmter Typ Leistungsmodul erträgt, bevor es wegen Ermüdung ausfällt. Die Figur 1 soll dabei lediglich zur beispielhaften Veranschaulichung des theoretischen Zusammenhangs dienen.

Es zeigt sich, dass gerade hohe thermische Änderungen $\Delta T$ für das Modul schädigend sind, da diese nur wenige tausend Mal ertragen werden. Kleine thermische Änderungen $\Delta T$ werden dagegen sehr häufig ertragen. Daher gilt es die thermischen Veränderungen $\Delta T$ möglichst gering zu halten, um die Lebensdauer zu optimieren.

Kühlung von Leistungsmodulen bzw. der Leistungseinheit

Das Kühlungssystem des Antriebssystems ist in der Regel so ausgelegt, dass Grenztemperaturen innerhalb des Pulswechselrichters bei maximaler spezifizierter Leistungsumsetzung nicht überschritten werden. Dazu wird bei aus der Praxis bekannten Systemen ein konstanter Kühlmittelvolumenstrom durch den Kühlkörper des Wechselrichters eingestellt, bei dem auch bei hohen Kühlmitteltemperaturen eine ausreichende Wärmeabfuhr sichergestellt ist. In manchen Fahrsituationen wird der Kühlmittelvolumenstrom zur Effizienzsteigerung verringert, wenn auf Grund der Umgebungstemperaturen oder der Lastsituation ein geringerer Verlustleistungseintrag vorliegt. In erster Linie kann der Volumenstrom jedoch als konstant angenommen werden. Genauso soll die Kühlmitteleintrittstemperatur als konstant angekommen werden. Kühlmitteltemperatur und - volumenstrom sind in der Regel durch das Kühlsystem vorgegeben und sind nicht durch den Wechselrichter beeinflusst.

Fig. 2 zeigt einen exemplarischen Verlauf verschiedener Parameter eines Wechselrichters ohne Bypass bei konstantem Kühlmittelvolumenstrom $Q_{KM}$ im Übergang zwischen zwei Arbeitspunkten der elektrischen Antriebsmaschine.

Im dargestellten Szenario steht das Kraftfahrzeug im Zeitbereich von 0 - ~10s. Hier sind die Drehzahl $n_{Motor}$, das Drehmoment $M_{Motor}$ und somit der Phasenstrom $I_{Phase}$ gleich 0. Da in diesem Zeitbereich keine Verlustleistung $P_{Verlust}$ entsteht, hat sich die Chiptemperatur $T_{Chip}$ thermisch eingeschwungen.

Im zweiten Zeitbereich -10 - ~ 20s beschleunigt das Fahrzeug und die Drehzahl $n_{Motor}$ steigt linear an. Zur Beschleunigung ist ein hohes Drehmoment $M_{Motor}$ nötig, welches durch einen hohen Phasenstrom $I_{Phase}$ bewirkt wird. Wegen der hohen entstehenden Verlustleistung $P_{Verlust}$, steigt die Chiptemperatur $T_{Chip}$ an und schwingt sich nach einigen Sekunden ein.

Nach der Beschleunigungsphase fährt das Kraftfahrzeug nun mit konstanter Geschwindigkeit weiter, was einer konstanten Drehzahl $n_{Motor}$ entspricht. Um den Fahrwiderstand zu überwinden ist nunmehr nur noch ein geringes Drehmoment $M_{Motor}$ nötig, welches durch einen geringen Phasenstrom $I_{Phase}$ eingeprägt wird. Ebenso ergibt sich eine niedrige Verlustleistung $P_{Verlust}$. Langsam wird die Verlustwärme aus den Chips über den thermischen Widerstand abgeführt, weshalb die Chiptemperatur $T_{Chip}$ langsam sinkt und sich erneut thermisch einschwingt.

Im zeitlichen Verlauf der Chiptemperatur $T_{Chip}$ sind die Temperaturänderungen $\Delta T1,1$ und $\Delta T2,1$ sichtbar, wobei $\Delta T1,1$ größer $\Delta T2,1$ ist, da die Änderungen des Verlustleistungseintrags zwischen den Fahrzuständen unterschiedlich sind. Wie oben erläutert, führen die Temperaturänderungen über die Nutzungsdauer zur Alterung der Leistungseinheit bzw. - module. Bei der Auslegung werden die Anzahl und die Höhe der Temperaturänderungen über Lebenszeit an Hand definierter Fahrprofile ermittelt. Meist kann die geforderte Lebensdauer mit erschwinglichen Leistungsmodulen nur schwer erreicht werden. Somit müssen meist teure Leistungsmodule aus der Industrietechnik ausgewählt werden.

Zur verbesserten Kühlung, insbesondere zur Reduzierung der absoluten Temperaturbeträge und der Temperaturänderungen wird deswegen ein verbesserter flüssigkeitsgekühlter Wechselrichter 1 vorgeschlagen.

Ein besonderer Vorteil des vorgeschlagenen Wechselrichters ist, dass keine Eingriffe in das gesamte Kühlsystem des Kraftfahrzeugs nötig sind. Die Kühlmitteltemperatur am Wechselrichtereingang sowie der Volumenstrom werden weiterhin durch das Kühlsystem des Kraftfahrzeugs vorgegeben.

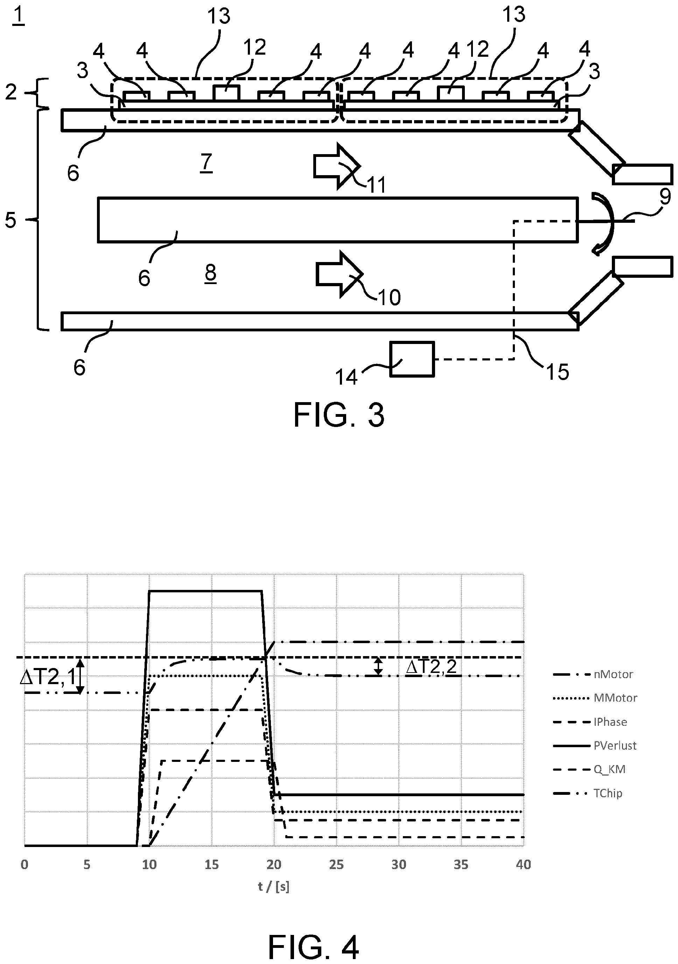

Figur 3 zeigt eine schematische Darstellung des Aufbaus eines flüssigkeitsgekühlten Wechselrichters 1 gemäß einer Ausführungsform der Erfindung.

Der flüssigkeitsgekühlte Wechselrichter 1 ist zur Ansteuerung eines (nicht dargestellten) elektrischen Antriebsmotors eines (ebenfalls nicht dargestellten) Kraftfahrzeugs ausgebildet. Das Kraftfahrzeug ist beispielhaft ein Nutzfahrzeug. Der Wechselrichter 1 ist in diesem Beispiel zwischen einem Gleichstromnetz und dem elektrischen Antriebsmotor angeordnet. Der Wechselrichter 1 ist zur Wandlung von Gleichstrom in Wechselstrom ausgebildet. Dazu umfasst der Wechselrichter 1 eine Leistungseinheit 2.

Die Leistungseinheit 2 weist eine auf einer Oberseite eines Substrats 3 angeordnete Schaltungsanordnung auf. Die Leistungseinheit 2 ist, hier lediglich beispielhaft, als MOSFET-Leistungsstufe ausgebildet ist, umfassend zwei mehrere Leistungs-Halbleiterelemente 4 aufweisende Leistungsmodule 13.

Das Substrat 3 ist in dieser Ausführungsform zur elektrischen Isolierung der Leistungseinheit 2 ausgebildet und umfasst eine Keramikplatte, die auch als Träger aller Bauteile eines Leistungsmoduls 13 fungiert. Die Keramikplatte dient als elektrischer Isolator zwischen den Hochvolt-aktiven Kreisen und einem Kühlkörper 6. Sie kann mit nur wenigen Millimetern Dicke aufgebaut werden.

Im Betrieb entstehen in den Leistungs-Halbleiterelementen 4 die bereits beschriebenen Schalt- und Durchgangsverluste, die hauptsächlich in Form von Verlustwärme bzw. eines thermischen Wärmeeintrags abgegeben werden.

Zur Kühlung der Leistungseinheit 2 umfasst der Wechselrichter 1 deswegen eine Temperiervorrichtung 5.

Die Tempereiervorrichtung 5 weist einen von einer Kühlflüssigkeit durchströmbaren Kühlkörper 6 auf. Auf den Kühlkörper 6 ist eine Unterseite des Substrats 3 aufgebracht. Vorliegend ist das Substrat 3 direkt auf den mit Kühlflüssigkeit durchströmbaren Kühlkörper 6 geklebt. Denkbar wäre auch, dass das Substrat 3 auf den Kühlkörper 6 gesintert ist.

Durch den Kühlkörper 6 erstreckt sich entlang der Unterseite des Substrats 3 eine Haupt-Kühlmittelteilung 7, die einen Fluidführungskanal für die den Kühlkörper 6 durchströmende Kühlflüssigkeit ausbildet.

Der Haupt-Kühlmittelleitung 7 der Temperiervorrichtung 5 des Wechselrichters 1 wird eingangsseitig eine Kühlflüssigkeit aus einem (nicht dargestellten) Kühlsystem des Kraftfahrzeugs zugeführt, deren Temperatur und Volumenstrom durch das Kühlsystem vorgegeben ist. Vorliegend wird durch das Kühlsystem ein konstanter Volumenstrom vorgegeben.

Strömt Kühlflüssigkeit durch die Haupt-Kühlmittelleitung 7 wird Kühlleistung von der Kühlflüssigkeit über das Substrat 3 in die Leistungseinheit 2 übertragen oder anders ausgedrückt, von der Leistungseinheit 2 erzeugte thermische Verlustwärme durch die Kühlflüssigkeit 11 abgeführt. Der Betrag der an die Leistungseinheit 2 übertragenen Kühlleistung ist proportional abhängig von dem in der Haupt-Kühlmittelleitung 7 strömenden Volumenstrom 11.

Die Temperiervorrichtung 5 weist eine von der Haupt-Kühlmittelleitung 7 abzweigende Bypass-Kühlmittelleitung 8 zur Reduzierung der an die Leistungseinheit 2 übertragenen Kühlleistung auf. Die Bypass-Kühlmittelleitung 8 erstreckt sich auf einer in Bezug auf die Haupt-Kühlmittelleitung 7 dem Substrat 3 abgewandten Seite durch den Kühlkörper 6. In einer weiteren, hier nicht dargestellten Ausführungsform, ist es auch denkbar, dass die Bypass-Kühlmittelleitung 8 aus dem Kühlkörper 6 herausgeführt ist und sich zumindest abschnittsweise an einer Außenseite des Kühlkörpers 6 erstreckt.

Die Bypass-Kühlmittelleitung 8 zweigt in Bezug auf die die Temperiervorrichtung 5 durchströmende Kühlflüssigkeit stromaufwärts der Leistungseinheit 2 von der HauptKühlmittelleitung 7 ab und mündet stromabwärts der Leistungseinheit 2 wieder in die HauptKühlmittelleitung 7 ein.

Die Temperiervorrichtung 5 weist ferner einen Volumenstromsteller 9 auf, der ausgebildet ist, einen von der Haupt-Kühlmittelleitung 7 in die Bypass-Kühlmittelleitung 8 abgezweigten Volumenstromanteil 10 der Kühlflüssigkeit einzustellen, um die von der Temperiervorrichtung 5 an die Leistungseinheit 2 übertragene Kühlleistung zu beeinflussen.

In der gezeigten Ausführungsform ist der Volumenstromsteller 9 im Bereich einer Zusammenführung der Bypass-Kühlmittelleitung 8 in die Haupt-Kühlmittelleitung 7 angeordnet. Der Volumenstromsteller 9 umfasst eine Klappe, die geeignet ist, den in die Bypass-Kühlmittelleitung 8 abzuzweigenden Volumenstromanteil 10 zu beeinflussen. Die in Figur 3 durch einen Pfeil symbolisierte Anstellung der Klappe bewirkt eine zumindest teilweise Schließung der Haupt-Kühlmittelleitung 7 oder der Bypass-Kühlmittelleitung 8. Dadurch beeinflusst der Volumenstromsteller 9 über die Klappe den Anteil des Kühlmittels, der durch die Haupt-Kühlmittelleitung 7 bzw. durch die Bypass-Kühlmittelleitung 8 fließt. Je kleiner der durch die Haupt-Kühlmittelleitung 7 strömender Volumenstrom 11 ist, desto weniger Kühlleistung wird an die Leistungseinheit 2 übertragen.

In der gezeigten Ausführungsform weist der flüssigkeitsgekühlte Wechselrichter 1 ferner eine Steuereinrichtung 14 zur Ansteuerung des Volumenstromstellers 9 auf. Hier lediglich beispielhaft steht die Steuereinrichtung 14 über eine elektrische Leitung 15 mit dem Volumenstromsteller 9 in Signalverbindung.

Die Steuereinrichtung 14 ist ausgebildet, den Volumenstromsteller 9 in Abhängigkeit von mindestens einer Größe anzusteuern, die ein Maß für einen vom Wechselrichter 1 anzusteuernden Arbeitspunkt des Antriebsmotors und die ein Maß für einen thermischen Verlusteintrag aus der Leistungseinheit 2 in den Kühlkörper 6 angibt.

Vorliegend ist die mindestens eine Größe ein vom Wechselrichter 1 einzustellenden Phasenstrom des Antriebsmotors. Das Ziel ist eine Einstellung der Kühlleistung so, dass das thermische Gefälle über das Substrat 3 in jedem Arbeitspunkt optimal ist, um die Temperatur der Leistungseinheit 2 möglichst konstant zu halten und somit Temperaturänderungen ΔT zu reduzieren. Die Steuereinrichtung 14 kann ferner ausgebildet sein, einen vom Wechselrichter 1 einzustellenden Phasenstrom des Antriebsmotors zu steuern und hierzu in an sich bekannter Weise eine Drehmoment- und Drehzahlanforderung als Maß für den einzustellenden Arbeitspunkt des Antriebsmotors zu erhalten.

Zur Reduktion von Temperaturschwankungen ist die Steuereinrichtung 14 vorliegend ausgebildet, den Volumenstromsteller 9 derart anzusteuern, dass der mittels des Volumenstromstellers 9 von der Haupt-Kühlmittelleitung 7 in die Bypass-Kühlmittelleitung 8 abgezweigte Volumenstromanteil 10 negativ korreliert ist mit einer von dem einzustellenden Arbeitspunkt abhängigen Höhe des thermischen Verlusteintrags aus der Leistungseinheit 2 in den Kühlkörper 6 und negativ korreliert ist, mit einer Höhe eines vom Wechselrichter 1 einzustellenden Phasenstroms. Hierzu sind in der Steuereinrichtung 14 entsprechende Kennfelder hinterlegt, die dem einzustellenden Phasenstrom entsprechende Stellgrößen des Volumenstromstellers zuordnen. Die Kennfelder können dabei vorab bestimmt werden, z. B. experimentell anhand von Prüfstandsmessungen und/oder anhand von Modellrechnungen. Die Kennfelder können weitere Betriebsgrößen, wie eine Drehmomentanforderung oder eine Drehzahlanforderung an den Antriebsmotor oder die mit den Temperatursensoren 12 erfasste Temperatur der Leistungseinheit 2 umfassen.

Beispielsweise leitet der Volumenstromsteller 9 die Kühlflüssigkeit hauptsächlich über die Bypass-Kühlmittelleitung 8, wenn das Kraftfahrzeug steht, d. h. wenn durch den Wechselrichter 1 kein Drehmoment und kein Phasenstrom einzustellen ist, und keine Verlustleistung und damit auch kein thermischer Verlusteintrag anfällt. In anderen Worten entspricht der von der Haupt-Kühlmittelleitung 7 in die Bypass-Kühlmittelleitung 8 abgezweigte Volumenstromanteil 10 größer 50 % eines Volumenstroms der durch den Kühlkörper 6 strömenden Kühlflüssigkeit, wenn kein Phasenstrom vom Wechselrichter 1 am Antriebsmotor einzustellen ist. Die Leistungseinheit 2 wird dann kaum gekühlt und die Temperatur der Leistungseinheit 2 fällt nicht stark ab. Beim Fahren, also wenn durch den Wechselrichter 1 ein Drehmoment und ein Phasenstrom einzustellen ist, zweigt der Volumenstromsteller 9 keinen oder nur einen geringen Volumenstromanteil 10 von der Haupt-Kühlmittelleitung 7 in die die Bypass-Kühlmittelleitung 8 ab, sodass sich die Leistungseinheit 2 stärker gekühlt wird. In anderen Worten wird der Volumenstromsteller 9 durch die Steuereinheit 14 derart angesteuert, dass bei niedrigen Verlustleistungseinträgen ein niedriger Kühlmittel-Volumenstrom in der Haupt-Kühlmittelleitung 7 anliegt und bei hohen Verlusten ein höherer KühlmittelVolumenstrom.

Wie in Figur 3 schematisch dargestellt, ist die Steuereinrichtung 14 in eine die Leistungseinheit 2 und die Temperiervorrichtung 5 umfassende Baugruppe integriert. In einer weiteren, hier nicht dargestellten Ausführungsform ist es jedoch auch denkbar, dass die Steuereinrichtung 14 baulich getrennt von einer die Leistungseinheit 2 und die Temperiervorrichtung 5 umfassenden Baugruppe angeordnet ist, beispielsweise als Funktionsmodul in einem Steuergerät integriert ist und in Signalverbindung mit dem Volumenstromsteller 9 steht.

Optional weist der Wechselrichter 1 einen im Bereich der Leistungseinheit 2 angeordneten Temperatursensor 12 auf. Vorliegend weist jedes Leistungsmodul 13 jeweils einen Temperatursensor 12 auf, der unmittelbar benachbart zu den Leistungs-Halbleiterelementen 4 auf dem Substrat 3 angeordnet ist. Der Temperatursensor 13 ist ausgebildet, die Temperatur der Leistungseinheit 2, hier der Leistungsmodule 13, zu erfassen. Die erfasste Temperatur kann bspw. ergänzend von der Steuereinrichtung 14 bei der Ansteuerung des Volumenstromstellers 9 berücksichtigt werden. Denkbar ist bspw. die Berücksichtigung im Sinne einer Plausibilitätsprüfung.

Figur 4 zeigt nochmals schematisch das bereits beschriebene Fahrprofil, jedoch unter Einsatz eines erfindungsgemäßen Wechselrichters. Dadurch, dass sich der Kühlmittelvolumenstrom nun dem Arbeitspunkt anpasst, kann die Höhe der Temperaturänderungen ΔT2,1 und ΔT2,2 im Vergleich zum Profil, dass durch einen Wechselrichter ohne Bypass erzeugt wird, reduziert werden. Somit ergibt sich in dem Fahrprofil über die Lebenszeit des Wechselrichters eine verbesserte Lebensdauer für die Leistungseinheit 2 bzw. die Leistungsmodule 13. Idealerweise können dadurch günstigere Automotive-Leistungsmodule, z. B: aus dem PKW-Bereich, auch für Nutzfahrzeuge eingesetzt werden.

Bezugszeichenliste

1   Flüssigkeitsgekühlter Wechselrichter
2   Leistungseinheit
3   Substrat
4   Leistung-Halbleiterelemente
5   Temperiervorrichtung
6   Kühlkörper
7   Haupt-Kühlmittelleitung
8   Bypass-Kühlmittelleitung
9   Volumenstromsteller
10  in die Bypass-Kühlmittelleitung abgezweigter Volumenstromanteil
11  in der Haupt-Kühlmittelleitung strömender Volumenstrom
12  Temperatursensor
13  Leistungsmodul
14  Steuereinrichtung
15  elektrische Leitung

**Patentansprüche**

1. Flüssigkeitsgekühlter Wechselrichter (1) zur Ansteuerung eines elektrischen Antriebsmotors eines Fahrzeugs, umfassend

a) eine Leistungseinheit (2), aufweisend eine auf einer Oberseite eines Substrats (3) angeordnete, Leistungs-Halbleiterelemente (4) aufweisende Schaltungsanordnung,
b) eine Temperiervorrichtung (5) zur Kühlung der Leistungseinheit (2), aufweisend
b1) einen von einer Kühlflüssigkeit durchströmbaren Kühlkörper (6), auf den eine Unterseite des Substrats (3) aufgebracht ist,
b2) eine Haupt-Kühlmittelteilung (7), die sich zumindest abschnittsweise durch den Kühlkörper (6) erstreckt,
b3) eine von der Haupt-Kühlmittelleitung (7) abzweigende Bypass-Kühlmittelleitung (8) zur Reduzierung einer an die Leistungseinheit (2) übertragenen Kühlleistung und
b3) einen Volumenstromsteller (9), der ausgebildet ist, einen von der Haupt-Kühlmittelleitung (7) in die Bypass-Kühlmittelleitung (8) abgezweigten Volumenstromanteil (10) der Kühlflüssigkeit einzustellen, um die von der Temperiervorrichtung (5) an die Leistungseinheit (2) übertragene Kühlleistung zu beeinflussen.

2. Flüssigkeitsgekühlter Wechselrichter (1) nach Anspruch 1, ferner aufweisend eine Steuereinrichtung (14) zur Ansteuerung des Volumenstromstellers (9) und/oder der Leistungseinheit (2), die ausgebildet ist, den Volumenstromsteller (9) in Abhängigkeit von mindestens einer Größe anzusteuern, die ein Maß für einen vom Wechselrichter (1) anzusteuernden Arbeitspunkt des Antriebsmotors angibt und/oder die ein Maß für einen thermischen Verlusteintrag aus der Leistungseinheit (2) in den Kühlkörper (6) angibt.

3. Flüssigkeitsgekühlter Wechselrichter (1) nach Anspruch 2, wobei die mindestens eine Größe einen vom Wechselrichter (1) einzustellenden Phasenstrom, ein vom Wechselrichter (1) einzustellendes Drehmoment und/oder eine vom Wechselrichter (1) einzustellende Drehzahl des Antriebsmotors umfasst.

4. Flüssigkeitsgekühlter Wechselrichter (1) nach Anspruch 2 oder 3, wobei die Steuereinrichtung (14) ausgebildet ist, zur Reduktion von Temperaturschwankungen den Volumenstromsteller (9) derart anzusteuern, dass der mittels des Volumenstromstellers (9) von der Haupt-Kühlmittelleitung (7) in die Bypass-Kühlmittelleitung (8) abgezweigte Volumenstromanteil (10)

a) negativ korreliert ist mit einer von dem einzustellenden Arbeitspunkt abhängigen Höhe des thermischen Verlusteintrags aus der Leistungseinheit (2) in den Kühlkörper (6); und/oder
b) negativ korreliert ist, mit einer Höhe eines vom Wechselrichter (1) einzustellenden Phasenstroms und/oder Drehmoments.

**5.** Flüssigkeitsgekühlter Wechselrichter (1) nach einem der Ansprüche 2 bis 4, wobei die Steuereinrichtung (14) ausgebildet ist, den Volumenstromsteller (9) derart anzusteuern, dass der von der Haupt-Kühlmittelleitung (7) in die Bypass-Kühlmittelleitung (8) abgezweigte Volumenstromanteil (10) größer 50 %, vorzugsweise größer 80 %, weiter vorzugsweise 100 %, des Volumenstroms der Kühlflüssigkeit entspricht, wenn kein Phasenstrom vom Wechselrichter (1) am Antriebsmotor einzustellen ist.

**6.** Flüssigkeitsgekühlter Wechselrichter (1) nach einem der vorhergehenden Ansprüche, wobei die Steuereinrichtung (14) ausgebildet ist, den Volumenstromsteller (9) derart anzusteuern, dass

a) zur Übertragung einer niedrigen, an die Leistungseinheit (2) übertragenen Kühlleistung ein überwiegender Volumenstromanteil (10) der im Kühlkörper (6) strömenden Kühlflüssigkeit mittels des Volumenstromstellers (9) in die Bypass-Kühlmittelleitung (8) abgezweigt wird, und/oder
b) zur Übertragung einer hohen, an die Leistungseinheit (2) übertragenen Kühlleistung kein Volumenstromanteil (10) oder kein überwiegender Volumenstromanteil (10) der im Kühlkörper (6) strömenden Kühlflüssigkeit mittels des Volumenstromstellers (9) in die Bypass-Kühlmittelleitung (8) abgezweigt wird.

**7.** Flüssigkeitsgekühlter Wechselrichter (1) nach einem der Ansprüche 2 bis 6, wobei die Steuereinrichtung (14)

a) in eine die Leistungseinheit (2) und die Temperiervorrichtung (5) umfassende Baugruppe integriert ist; oder
b) baulich getrennt von einer die Leistungseinheit (2) und die Temperiervorrichtung (5) umfassenden Baugruppe angeordnet ist, beispielsweise als Funktionsmodul in einem Steuergerät integriert ist und in Signalverbindung mit dem Volumenstromsteller (9) steht.

**8.** Flüssigkeitsgekühlter Wechselrichter (1) nach einem der vorhergehenden Ansprüche, wobei der Volumenstromsteller (9) eine Klappe umfasst, die geeignet ist, den in die Bypass-Kühlmittelleitung (8) abzuzweigenden Volumenstromanteil (10) zu beeinflussen.

**9.** Flüssigkeitsgekühlter Wechselrichter (1) nach einem der vorhergehenden Ansprüche, wobei

a) das Substrat (3) zur elektrischen Isolierung der Leistungseinheit (2) eine Keramikplatte umfasst und/oder als Keramikplatte ausgebildet ist; und/oder
b) die Leistungseinheit (2) als IGBT- oder MOSFET-Leistungsstufe ausgebildet ist, umfassend zumindest ein mehrere Leistungs-Halbleiterelemente (4) aufweisendes Leistungsmodul (13).

**10.** Flüssigkeitsgekühlter Wechselrichter (1) nach einem der vorhergehenden Ansprüche, wobei die Haupt-Kühlmittelleitung (7) sich zumindest abschnittsweise entlang der Unterseite des Substrats (3) durch den Kühlkörper (6) erstreckt, und

a) wobei die Bypass-Kühlmittelleitung (8) sich auf einer in Bezug auf die Haupt-Kühlmittelleitung (7) dem Substrat (3) abgewandten Seite durch den Kühlkörper (6) erstreckt, oder
b) wobei die Bypass-Kühlmittelleitung (8) aus dem Kühlkörper (6) herausgeführt ist und sich zumindest abschnittsweise an einer Außenseite des Kühlkörpers (6) erstreckt.

**11.** Flüssigkeitsgekühlter Wechselrichter (1) nach einem der vorhergehenden Ansprüche, wobei die Bypass-Kühlmittelleitung (8) in Bezug auf die die Temperiervorrichtung (5) durchströmende Kühlflüssigkeit stromaufwärts der Leistungseinheit (2) von der Haupt-Kühlmittelleitung (7) abzweigt und/oder stromabwärts der Leistungseinheit (2) in die Haupt-Kühlmittelleitung (7) mündet.

**12.** Flüssigkeitsgekühlter Wechselrichter (1) nach einem der vorhergehenden Ansprüche, wobei der Volumenstromsteller (9) im Bereich einer Abzweigung der Bypass-Kühlmittelleitung (8) von der Haupt-Kühlmittelleitung (7) oder im Bereich einer Zusammenführung der Bypass-Kühlmittelleitung (8) in die Haupt-Kühlmittelleitung (7) angeordnet ist.

**13.** Flüssigkeitsgekühlter Wechselrichter (1) nach einem der Ansprüche 2 bis 12, ferner aufweisend einen im Bereich der Leistungseinheit (2) angeordneten Temperatursensor (12), der ausgebildet ist, die Temperatur der Leistungseinheit (2) zu erfassen, und wobei die Steuereinrichtung (14) ausgebildet ist, den Volumenstromsteller (9) in Abhängigkeit von der erfassten Temperatur anzusteuern.

14. Kraftfahrzeug, vorzugsweise Nutzfahrzeug, umfassend einen flüssigkeitsgekühlten Wechselrichter (1) nach einem der Ansprüche 1 bis 13.

15. Kraftfahrzeug nach Anspruch 14, ferner umfassend einen elektrischen Antriebsmotor und ein Kühlsystem für den Antriebsmotor, wobei der Haupt-Kühlmittelleitung (7) der Temperiervorrichtung (5) des Wechselrichters (1) eingangsseitig eine Kühlflüssigkeit aus dem Kühlsystem zugeführt ist, deren Temperatur und Volumenstrom durch das Kühlsystem vorgegeben ist.

FIG. 1

FIG. 2

FIG. 3

FIG. 4

Legend (FIG. 4):
- nMotor
- MMotor
- IPhase
- PVerlust
- Q_KM
- TChip

Europäisches
Patentamt

European
Patent Office

Office européen
des brevets

# EUROPÄISCHER RECHERCHENBERICHT

**Nummer der Anmeldung**

**EP 22 15 7647**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2015 225644 A1 (SCHAEFFLER TECHNOLOGIES AG [DE]) 22. Juni 2017 (2017-06-22) * Abbildungen 1,5 * * Absätze [0012], [0025], [0030] * ----- | 1-15 | INV. H05K7/20 |
| X | DE 10 2013 225450 B3 (BOSCH GMBH ROBERT [DE]) 26. März 2015 (2015-03-26) * Abbildungen 1-3 * * Absätze [0026], [0029], [0054] * ----- | 1-15 | |
| X | DE 10 2014 208499 A1 (SIEMENS AG [DE]) 12. November 2015 (2015-11-12) * Absätze [0002], [0014], [0015], [0025], [0026] * * Abbildung 3 * ----- | 1-15 | |
| X | DE 10 2019 103735 A1 (PORSCHE AG [DE]) 20. August 2020 (2020-08-20) * Absätze [0006], [0007], [0027], [0029], [0031] * * Abbildung 2 * ----- | 1-15 | |
| A | EP 1 858 313 A1 (HITACHI LTD [JP]) 21. November 2007 (2007-11-21) * Abbildungen 1,2,5,14 * * Absatz [0111] * ----- | 1-15 | RECHERCHIERTE SACHGEBIETE (IPC) H05K |
| A | DE 10 2016 218020 A1 (BOSCH GMBH ROBERT [DE]) 5. April 2018 (2018-04-05) * Absätze [0012], [0015], [0016], [0018] * * Abbildungen 1b,3-5 * ----- | 1-15 | |
| A | DE 10 2014 205525 A1 (SIEMENS AG [DE]) 1. Oktober 2015 (2015-10-01) * Abbildungen 1-4 * * Absätze [0038], [0043], [0051] * ----- | 1-15 | |

Der vorliegende Recherchenbericht wurde für alle Patentansprüche erstellt

| Recherchenort | Abschlußdatum der Recherche | Prüfer |
|---|---|---|
| Den Haag | 4. August 2022 | Dinkla, Remko |

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 22 15 7647

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-08-2022

| Im Recherchenbericht angeführtes Patentdokument | Datum der Veröffentlichung | Mitglied(er) der Patentfamilie | Datum der Veröffentlichung |
|---|---|---|---|
| DE 102015225644 A1 | 22-06-2017 | CN 108367669 A | 03-08-2018 |
| | | DE 102015225644 A1 | 22-06-2017 |
| | | DE 112016005791 A5 | 06-09-2018 |
| | | JP 6882300 B2 | 02-06-2021 |
| | | JP 2019502347 A | 24-01-2019 |
| | | KR 20180095572 A | 27-08-2018 |
| | | US 2020276899 A1 | 03-09-2020 |
| | | WO 2017101935 A1 | 22-06-2017 |
| DE 102013225450 B3 | 26-03-2015 | DE 102013225450 B3 | 26-03-2015 |
| | | EP 2884204 A2 | 17-06-2015 |
| DE 102014208499 A1 | 12-11-2015 | CN 105097730 A | 25-11-2015 |
| | | DE 102014208499 A1 | 12-11-2015 |
| DE 102019103735 A1 | 20-08-2020 | CN 212604474 U | 26-02-2021 |
| | | DE 102019103735 A1 | 20-08-2020 |
| EP 1858313 A1 | 21-11-2007 | CN 101064289 A | 31-10-2007 |
| | | CN 101783579 A | 21-07-2010 |
| | | EP 1858313 A1 | 21-11-2007 |
| | | JP 4857017 B2 | 18-01-2012 |
| | | JP 2007295765 A | 08-11-2007 |
| | | US 2007253164 A1 | 01-11-2007 |
| | | US 2011032676 A1 | 10-02-2011 |
| DE 102016218020 A1 | 05-04-2018 | CN 107846815 A | 27-03-2018 |
| | | DE 102016218020 A1 | 05-04-2018 |
| DE 102014205525 A1 | 01-10-2015 | KEINE | |

EPO FORM P0461

Für nähere Einzelheiten zu diesem Anhang : siehe Amtsblatt des Europäischen Patentamts, Nr.12/82